(19) **Europäisches Patentamt / European Patent Office / Office européen des brevets**

(11) **EP 2 278 855 A1**

(12) # EUROPEAN PATENT APPLICATION
published in accordance with Art. 153(4) EPC

(43) Date of publication:
**26.01.2011 Bulletin 2011/04**

(21) Application number: **09726135.8**

(22) Date of filing: **25.03.2009**

(51) Int Cl.:
**H05B 33/02** (2006.01)  **H01L 51/50** (2006.01)
**H05B 33/10** (2006.01)

(86) International application number:
**PCT/JP2009/056781**

(87) International publication number:
**WO 2009/119889 (01.10.2009 Gazette 2009/40)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **28.03.2008 JP 2008086245**

(71) Applicant: **Sumitomo Chemical Company, Limited Tokyo 104-8260 (JP)**

(72) Inventor: **YAMAMOTO, Kyoko Tsukuba-shi Ibaraki 305-0045 (JP)**

(74) Representative: **Duckworth, Timothy John J.A. Kemp & Co. 14 South Square Gray's Inn London WC1R 5JJ (GB)**

(54) **ORGANIC ELECTROLUMINESCENT DEVICE**

(57) An organic electroluminescent device with a configuration in which a functional layer, a transparent first electrode, a light emitting layer, and a second electrode are disposed in layer in this order, wherein a surface of the functional layer has a plurality of depressions and projections having a height of 0.5 μm to 100 μm, the surface being located on a side opposite to a side where the first electrode is, and the refractive index n1 of the first electrode and the refractive index n2 of the functional layer satisfy the following Expression (1).

$$0.3 \geq n1 - n2 \geq 0 \quad \cdots \text{Expression (1)}$$

Figure 1

**Description**

TECHNICAL FIELD

The present invention relates to an organic electroluminescent device, a lighting unit, a display unit, and a manufacturing method thereof.

BACKGROUND ART

An organic electroluminescent (Electro Luminescence: its abbreviation is EL) device is constituted to include a light emitting layer containing an organic substance, and a pair of electrodes which sandwich the light emitting layer. When a voltage is applied to the organic EL device, electrons are injected from a negative electrode, while at the same time holes are injected from a positive electrode, and the electrons and the holes are coupled to each other, whereby light is emitted. Light emitted from the light emitting layer is extracted from at least one of the pair of electrodes. Consequently, a transparent electrode is used for the electrode from which light is extracted. The transparent electrode includes a metal oxide such as an indium tin oxide (ITO: Indium Tin Oxide) or the like. In general, a refractive index of a metal oxide used in the transparent electrode is higher than that of a substrate provided with the organic EL device so that total reflection occurs at the interface between the transparent electrode and the substrate. Most of the light emitted from the light emitting layer is not extracted outside the organic EL device due to such reflection and the like, and light extraction efficiency is not necessarily high. Accordingly, there is proposed an organic EL device having a structure capable of suppressing such reflection. For example, there is an organic EL device using a glass substrate provided with a light condensing layer displaying light condensing properties (see, e.g., JP-A-2003-86353). The light condensing layer is comprised of a light condensing structure such as a micro lens and a transparent resin which covers the light condensing structure. As the transparent resin, a resin having the refractive index higher than that of the light condensing structure is used. By providing such light condensing layer on the glass substrate, the occurrence of the total reflection on the surface of the glass substrate is suppressed, and the light extraction efficiency is thereby improved.

DISCLOSURE OF THE INVENTION

Even when such light condensing layer is provided on the glass substrate, the total reflection occurs at the interface between the light condensing layer and the glass substrate so that the light extraction efficiency from the organic EL device is not necessarily sufficiently high and, as a result, an organic EL device having higher light extraction efficiency is in demand.
An obj ect of the present invention is to provide an organic EL device, a lighting unit, and a display unit each having high light extraction efficiency, and a manufacturing method thereof.
The present invention is an organic electroluminescent device with a configuration in which a functional layer, a transparent first electrode, a light emitting layer, and a second electrode are disposed in layer in this order, wherein a surface of the functional layer has a plurality of depressions and projections having a height of 0.5 $\mu$m to 100 $\mu$m, the surface being located on a side opposite to a side where the first electrode is, and the refractive index n1 of the first electrode and the refractive index n2 of the functional layer satisfy the following Expression (1).

$$0.3 \geq n1 - n2 \geq 0 \quad \cdots \text{Expression (1)}$$

The present invention is the organic electroluminescent device further including a low refractive index layer provided in contact with the surface of the functional layer, the surface being located on a side opposite to a side where the first electrode is, wherein the refractive index n1 of the first electrode, the refractive index n2 of the functional layer, and the refractive index n3 of the low refractive index layer satisfy the following Expression (2).

$$n1 \geq n2 > n3 \quad \cdots (2)$$

The present invention is the organic electroluminescent device, wherein the center line average roughness Ra of a surface of the functional layer, the surface facing the first electrode, is not more than 10 nm.
The present invention is the organic electroluminescent device, wherein the interval at which the depressions and projections are disposed is from 0.5 $\mu$m to 100 $\mu$m.

EP 2 278 855 A1

The present invention is the organic electroluminescent device, wherein the surface shape of each of the depressions and projections is a concave surface or a convex surface.

The present invention is the organic electroluminescent device, wherein the concave surface or the convex surface is a hemispherical surface.

The present invention is the organic electroluminescent device, wherein the surface shape of each of the depressions and projections is constituted by a plurality of planes.

The present invention is the organic electroluminescent device, wherein the depressions and projections are mutually irregular in shape.

The present invention is a lighting unit comprising the organic electroluminescent device.

The present invention is a display unit comprising a plurality of organic electroluminescent devices.

The present invention is a method of manufacturing an organic electroluminescent device with a configuration in which a low refractive index layer, a functional layer, a transparent first electrode, a light emitting layer, and a second electrode are disposed in layer in this order, wherein the refractive index n1 of the first electrode, the refractive index n2 of the functional layer, and the refractive index n3 of the low refractive index layer satisfy the following Expression (3),

$$\begin{cases} 0.3 \geq n1 - n2 \geq 0 \\ n1 \geq n2 > n3 \end{cases} \cdots (3)$$

the method comprising the steps of forming a plurality of depressions and projections having a height of 0.5 $\mu$m to 100 $\mu$m on a surface to form the low refractive index layer, applying an application liquid containing a material which is to form the functional layer to the surface provided with the plurality of depressions and projections of the low refractive index layer to form the functional layer, forming the first electrode, forming the light emitting layer, and forming the second electrode.

The present invention is the method of manufacturing the organic electroluminescent device, wherein the plurality of depressions and projections are formed by an imprint method in the step of forming the low refractive index layer.

The present invention is the method of manufacturing the organic electroluminescent device, wherein a surface portion of the low refractive plate is selectively removed by a photolithography method to form the plurality of depressions and projections in the step of forming the low refractive index layer.

The present invention is the method of manufacturing the organic electroluminescent device, wherein a surface portion of the low refractive plate is selectively removed by dry etching to form the depressions and projections in the step of forming the low refractive index layer.

BRIEF DESCRIPTION OF THE DRAWINGS

FIG. 1 is a view schematically showing an organic EL device 1 according to one embodiment of the present invention;
FIG. 2 is a view schematically showing an organic EL device 11 according to another embodiment of the present invention; and
FIG. 3 is a view schematically showing an organic EL device 21 according to still another embodiment of the present invention.

EXPLANATION OF REFERENCE

1, 11, 21  organic EL device
2, 22  low refractive index layer
3, 13  functional layer
4, 14  first electrode
5, 15  light emitting layer
6, 16  second electrode
7, 17  hole injecting layer

## MODE FOR CARRYING OUT THE INVENTION

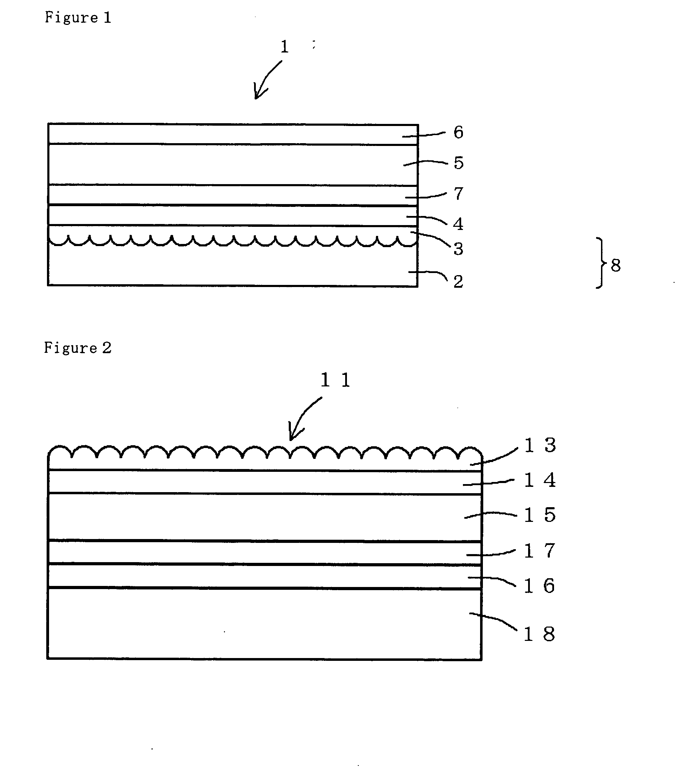

FIG. 1 is a view schematically showing an organic electroluminescent device (hereinbelow occasionally referred to as an organic EL device) 1 according to one embodiment of the present invention. The organic EL device 1 is constituted by laminating at least a low refractive index layer 2, a functional layer 3, a transparent first electrode 4, a light emitting layer 5, and a second electrode 6 in this order. On the surface of the functional layer 3 on the side opposite to the side with the first electrode, a plurality of repressions and projections having a height of 0.5 $\mu$m to 100 $\mu$m are formed. A refractive index n1 of the first electrode 1 and a refractive index n2 of the functional layer satisfy the following Expression (1).

$$0.3 \geq n1 - n2 \geq 0 \quad \cdots \text{Expression (1)}$$

Further, the refractive index n1 of the first electrode, the refractive index n2 of the functional layer, and a refractive index n3 of the low refractive index layer satisfy the following Expression (2).

$$n1 \geq n2 > n3 \quad \cdots (2)$$

Between the first and second electrodes 4 and 6, a plurality of light emitting layers and / or one or a plurality of layers different from the light emitting layer may also be provided instead of one light emitting layer 5. In the organic EL device 1 of the present embodiment, a hole injecting layer 7 is provided between the first electrode 4 and the light emitting layer 5. The low refractive index layer 2 is provided so as to be in contact with the surface of the functional layer 3 on the side opposite to the side with the first electrode 4. In the present embodiment, a laminated body of the low refractive index layer 2 and the functional layer 3 functions as a substrate 8. The organic EL device 1 of the present embodiment is constituted by laminating the substrate 8, the first electrode 4, the hole injecting layer 7, the light emitting layer 5, and the second electrode 6 in this order. Although the substrate 8 and the first electrode 4 are in contact with each other in the present embodiment, for example, a thin insulating layer or barrier layer may also be provided between the substrate 8 and the first electrode 4.

The first electrode 4 of the present embodiment exhibits light permeability and also functions as a positive electrode, while the second electrode 6 reflects visible light and also functions as a negative electrode. The substrate 8 displays light permeability. Consequently, light emitted from the light emitting layer 5 toward the first electrode 4 is passed through the first electrode 4 and the substrate 8 to be extracted to the outside. Light emitted from the light emitting layer 5 toward the second electrode 6 is reflected by the second electrode 6, and is passed through the first electrode 4 and the substrate 8 to be extracted to the outside. That is, the organic EL device 1 of the present embodiment is a bottom emission, type device in which light is extracted from the substrate 8.

As a modification, it is also possible to constitute a bottom emission type organic EL device in which the first electrode serves as the negative electrode and the second electrode serves as the positive electrode, and it is also possible to constitute a double-sided light emitting organic EL device in which the electrode exhibiting light permeability is used as the second electrode to extract light also from the side with the second electrode.

As indicated by Expression (1), since a difference between respective refractive indexes of the functional layer 3 and the first electrode 4 is small, it is possible to lower reflectivity at the interface between the functional layer 3 and the first electrode 4, and suppress the total reflection. This allows light to efficiently propagate from the first electrode 4 to the functional layer 3.

Since a plurality of depressions and projections having a height of 0.5 $\mu$m to 100 $\mu$m are formed on the surface of the functional layer 3, light is scattered, refracted, or condensed at the interface between the functional layer 3 and the low refractive index layer 2. This allows reflection at the interface between the functional layer 3 and the low refractive index layer 2 to be suppressed, and allows light having entered the functional layer 3 from the first electrode 4 to efficiently enter the low refractive layer 2. The height of the depressions and projections is preferably from 0.7 $\mu$m to 50 $\mu$m, and more preferably from 1 $\mu$m to 30 $\mu$m. It is to be noted that the height mentioned herein is a height of the depressions and projections in a direction vertical to the surface of the functional layer 3 on the side with the first electrode 4.

The height of the depressions and projections mentioned herein means an average height, and can be measured using a contact stylus roughness meter or the like.

As indicated by Expression (2), since the refractive index of the low refractive index layer 2 is lower than those of the first electrode 4 and the functional layer 3 and, in particular, is closer to the refractive index of the air than the functional layer 3, it is possible to suppress the total reflection occurring at the interface with the air, and efficiently extract light having entered the low refractive index layer 2 to the outside. Moreover, by forming a plurality of depressions and projections having the height of 0.5 $\mu$m to 100 $\mu$m at the interface of the low refractive index layer 2 with the air, it is possible to extract the light having entered the low refractive index layer 2 to the outside more effectively.

As has been described above, by causing light emitted from the light emitting layer 5 to efficiently propagate to the first electrode 4, the functional layer 3, the low refractive layer 2, and the air sequentially, it is possible to improve light extraction efficiency.

In prior art techniques, the light condensing structure is provided on the glass substrate so that a part of light is reflected at the interface between the light condensing layer and the glass substrate, while in the organic EL device 1 of the present embodiment, a structure corresponding to the light condensing structure in the prior art techniques is formed in the low refractive index layer 2, and the low refractive layer 2 in which the light condensing structure and the glass substrate in the prior art techniques are integrally formed is used, whereby the reflection occurring at the interface between the light condensing layer and the glass substrate in the prior art techniques is eliminated to improve the light extraction efficiency.

The depressions and projections on the surface of the functional layer 3 on the side with the first electrode 4 influence smoothness of the first electrode 4 to be laminated on the surface of the functional layer 3. When the smoothness of the first electrode 4 is low, a short circuit may occur due to projections of the first electrode 4. Consequently, a center line average roughness Ra of the first electrode 4 is preferably small and, in order to form such first electrode 4, the center line average roughness Ra of the surface of the functional layer 3 on the side with the first electrode 4 is preferably small. The center line average roughness Ra of the surface of the functional layer 3 on the side with the first electrode 4 is preferably not more than 100 nm, more preferably not more than 50 nm, even more preferably not more than 10 nm, and still even more preferably not more than 3 nm.

An interval at which the depressions and projections are disposed is, e.g., from 0.4 $\mu$m to 200 $\mu$m, preferably from 0.5 $\mu$m to 100 $\mu$m, and more preferably from 0.8 $\mu$m to 50 $\mu$m. By disposing the depressions and projections at the interval mentioned above, it is possible to enhance the effects of scattering, refracting, and condensing light to improve the light extraction efficiency.

The surface shape of each of the depressions and projections is a concave surface or a convex surface. With this, the functional layer 3 functions as a plurality of micro lenses. When a plurality of the concave surfaces which are depressed toward the first electrode 4 are formed on the surface of the functional layer 3 on the side with the low refractive index layer 2, the functional layer 3 functions as a plurality of concave lenses to the light emitting layer 5. When a plurality of the convex surfaces which are projected toward the low refractive index layer 2 are formed on the surface of the functional layer 3 on the side with the low refractive index layer 2 (see FIG. 1), the functional layer 3 functions as a plurality of convex lenses to the light emitting layer 5. Thus, since the individual depressions and projections function as the lenses, it is possible to enhance the effects of scattering, refracting, and condensing light to improve the light extraction efficiency.

The concave surface or the convex surface described above is preferably a hemispherical surface. By including such hemispherical concave surface or convex surface, it is possible to enhance the effects of scattering, refracting, and condensing light to improve the light extraction efficiency.

As a modification, the surface of each of the depressions and projections may be constituted by a plurality of planes. For example, the surface of each of the depressions and projections is constituted by a plurality of planes of a polygonal pyramid except its bottom face.

As a modification, the shapes of each depression and each projection may be mutually regular or irregular, and are preferably mutually irregular. For example, when the depression and the projection have shapes having mutual regularity, wavelength dependence is seen in properties of extracted light. However, by forming the shapes of the depression and the projection mutually irregularly, it is possible to reduce the wavelength dependence in the properties of the extracted light. For example, when a plurality of the organic EL devices are formed on a substrate, and each of the EL device emits light with a given spectrum, in accordance with the spectrum of light which mainly passes through depressions and projections, the depressions and projections may be formed into specific shapes so as to reduce the reflection of the light which mainly passes through them. For example, the shapes of the depressions and projections through which mainly red light passes may be formed differently from those of the depressions and projections through which mainly blue light passes.

Subsequently, a description will be given of details of a manufacturing method and a structure of the organic EL device 1. The manufacturing method of the organic EL device 1 of the present embodiment is a manufacturing method of an organic electroluminescent device constituted by laminating at least a low refractive index layer, a functional layer, a transparent first electrode, a light emitting layer, and a second electrode in this order in which a refractive index n1 of the first electrode, a refractive index n2 of the functional layer, and a refractive index n3 of the low refractive index layer satisfy the following Expression (3):

$$\begin{cases} 0.3 \geq n1 - n2 \geq 0 \\ n1 \geq n2 > n3 \end{cases} \cdots (3)$$

and the manufacturing method includes the steps of forming a plurality of depressions and projections having a height of 0.5 $\mu$m to 100 $\mu$m on a surface to form the low refractive index layer, applying an application liquid containing a material which is to serve as the functional layer on the surface formed with the plurality of depressions and projections of the low refractive index layer to form the functional layer, forming the first electrode, forming the light emitting layer, and forming the second electrode. It is to be noted that the manufacturing method of the organic EL device of the present embodiment further includes the step of forming a hole injecting layer between the first electrode and the light emitting layer.

<Low Refractive Index Layer>

There is preferably used the low refractive index layer which has high transmittance of light in a visible light region, and does not change in the step of forming the organic EL device. The low refractive index layer may be a rigid plate or a flexible plate, and, for example, a glass plate, a plastic plate, a polymeric film, a silicon plate, and a laminated plate obtained by laminating these are preferably used. As a resin forming the plastic plate or the polymeric film, it is preferable to use a resin which is not dissolved in an application liquid which is used when, e.g., the light emitting layer 5 and the hole injecting layer 7 are formed by application methods described later. Specifically, examples of the resin include polyolefin-based resins such as low-density or high-density polyethylene, an ethylene-propylene copolymer, an ethylene-butene copolymer, an ethylene-hexene copolymer, an ethylene-octene copolymer, an ethylene-norbornene copolymer, an ethylene-DMON copolymer (DMON is an abbreviation of dimethanooctahydronaphthalene), polypropylene, an ethylene-vinyl acetate copolymer, an ethylene-methyl methacrylate copolymer, and an ionomer resin; polyester-based resins such as polyethylene terephthalate, polybutylene terephthalate, and polyethylene naphthalate; nylon-6, nylon-6, 6, a metaxylenediamine-adipic acid condensation polymer; an amide-based resin such as polymethyl methacrylimide; an acryl-based resin such as polymethyl methacrylate; styrene-acrylonitrile-based resins such as polystyrene, a styrene-acrylonitrile copolymer, a styrene-acrylonitrile-butadiene copolymer, and polyacrylonitrile; hydrophobic cellulose-based resins such as cellulose triacetate and cellulose diacetate; halogen-containing resins such as polyvinyl chloride, polyvinylidene chloride, polyvinylidene fluoride, and polytetrafluoroethylene; hydrogen-bonding resins such as polyvinyl alcohol, an ethylene-vinyl alcohol copolymer, and a cellulose derivative; and engineering plastic resins such as a polycarbonate resin, a polysulfone resin, a polyethersulfone resin, a polyetheretherketone resin, a polyphenylene oxide resin, a polymethylene oxide resin, a polyarylate resin, and a liquid crystal resin.

Since heat resisting properties in a manufacturing process of the organic EL device is required of the low refractive index layer, among the resins mentioned above, the resin having a glass transition temperature Tg of not less than 150°C is preferable, the resin having the glass transition temperature Tg of not less than 180°C is more preferable, and the resin having the glass transition temperature Tg of not less than 200°C is even more preferable.

The low refractive index layer may includes a material having high barrier properties through which oxygen and water vapor contained in the atmosphere of the organic EL device are unlikely to pass. For example, an inorganic layer including an inorganic substance such as a metal, a metal oxide, a metal nitride, a metal carbide, or a metal oxynitride, a laminated body of the above-described inorganic layer and an organic layer, or an inorganic-organic hybrid layer is preferably used. As the inorganic layer, a thin film layer which is stable in the air is preferable, and specific examples of the thin film layer include thin film layers made of silica, alumina, titania, indium oxide, tin oxide, titanium oxide, zinc oxide, indium tin oxide (ITO), aluminum nitride, silicon nitride, silicon carbide, silicon oxynitride, and a combination thereof. The thin film layers made of aluminum nitride, silicon nitride, and silicon oxynitride are more preferable, and the thin film layer made of silicon oxynitride is even more preferable.

As long as the low refractive index layer satisfies Expression (2), the low refractive index layer is appropriately selected from those shown as examples in accordance with the respective refractive indexes of the functional layer 3 and the first electrode 4. The refractive index of the low refractive index layer in the case where the low refractive index layer is constituted of a plurality of materials corresponds to a value of the refractive index of the entire low refractive index layer.

The refractive index n3 of the low refractive index layer is determined by a material forming the low refractive index layer. For example, in the case of glass, the refractive index n3 is about 1.5. In the case of polycarbonate, the refractive index n3 is 1.58. In the case of polyethylene terephthalate, the refractive index n3 is 1.49. In the case of polyethersulfone, the refractive index n3 is 1. 65. In the case of polyethylene naphthalate, the refractive index n3 is 1.50.

Examples of a method for forming the plurality of depressions and projections include an imprint method (embossing method), a photolithography method, a dry etching method, a method in which a surface is engraved with a tool having roughness, and a method in which a roughness structure is formed by utilizing self-organization. In terms of formation of the roughness structure as designed with high precision, it is preferable to use the imprint method (embossing method), the photolithography method, and the dry etching method.

For example, in the imprint method, by pushing a die formed with a plurality of depressions and projections on its surface against a film, the surface shape of the die can be transferred onto the low refractive index layer. In the photolithography method, for example, a photo-setting resin is applied, and the applied film is selectively irradiated with light and further developed, whereby a surface portion of the applied film is selectively removed, and the low refractive index layer formed with the plurality of depressions and projections on the surface can be thereby obtained. For example, a photoresist is applied to a glass substrate, the applied film is selectively removed, a mask formed with a plurality of holes is formed on the surface of the glass substrate, and the surface of the glass substrate is further selectively removed by dry etching or wet etching, whereby the glass substrate formed with the plurality of depressions and projections, i.e., the low refractive index layer can be obtained. The surfaces of the glass substrate and a resin film are removed by the dry etching method, and the low refractive index layer can be thereby obtained.

<Functional Layer>

As the functional layer, there is preferably used the functional layer which has high transmittance of light in a visible light region, and does not change in the step of forming the organic EL device, and the functional layer may be a rigid plate or a flexible plate. The functional layer is constituted by, e.g., an inorganic polymer, an inorganic-organic hybrid material, and the like. The inorganic-organic hybrid material includes a compound in which inorganic and organic substances are hybrid at a molecular level, and a mixture in which the inorganic substance is dispersed in the organic substance. Since the total reflection is suppressed better when the difference between the respective refractive indexes of the functional layer and the transparent electrode is smaller, the refractive index of the functional layer is preferably not less than 1.75.

The functional layer is preferably formed by applying an application liquid containing a material which is to serve as the functional layer in terms of easiness in manufacturing steps. When the application liquid is applied to the low refractive index layer formed with the plurality of depressions and projections having the height of 0.5 $\mu$m to 100 $\mu$m on the surface, the depressions and the projections of the low refractive index layer are filled with the the application liquid and, when the application liquid is further cured, it is possible to easily obtain the functional layer formed with the plurality of depressions and projections having the height of 0.5 $\mu$m to 100 $\mu$m. By using the application method in this manner, it is possible to form the surface of the functional layer 3 on the side with the first electrode 4 flatly. The application liquid may be a solution or a fluid dispersion, and is a liquid composition to which an organic solvent, a surface active agent, an adhesion enhancing agent, a crosslinking agent, a sensitizing agent, or a photosensitive agent is added as necessary. Examples of the liquid composition include a silicon-based inorganic polymer, a composition in which high refractive index nanoparticles are dispersed in a monomer thermoplastic resin containing an aromatic, a composition in which the high refractive index nanoparticles are dispersed in a photo-setting monomer, and a composition in which the high refractive index nanoparticles are dispersed in a thermosetting monomer. It is possible to cure an application film obtained by applying the application liquid containing the material which is to serve as the functional layer to the low refractive index layer by performing processing such as light irradiation, heating, drying, and pressurization with respect to the application film.

The functional layer may include a material having high barrier properties through which oxygen and water vapor contained in the atmosphere of the organic EL device are unlikely to pass. As the material having high barrier properties, for example, an inorganic layer including an inorganic substance such as a metal, a metal oxide, a metal nitride, a metal carbide, or a metal oxynitride, a laminated body of the inorganic layer and an organic layer, or an inorganic-organic hybrid layer is preferable. As the inorganic layer, a thin film layer which is stable in the air is preferably, and examples of the thin film layer include thin film layers made of silica, alumina, titania, indium oxide, tin oxide, titanium oxide, zinc oxide, indium tin oxide, aluminum nitride, silicon nitride, silicon carbide, silicon oxynitride, and a combination thereof. The thin film layers made of aluminum nitride, silicon nitride, and silicon oxynitride are more preferable, and the thin film layer made of silicon oxynitride is even more preferable. As long as the functional layer satisfies Expressions (1) and (2), the functional layer is appropriately selected from those shown as examples in accordance with the respective refractive indexes of the low refractive index layer 2 and the first electrode 4. The refractive index of the functional layer preferably satisfies the relationships of Expressions (1) and (2), and is not less than 1.75. The refractive index of the functional layer in the case where the functional layer is constituted of a plurality of materials corresponds to a value of the refractive index of the entire functional layer.

The refractive index n2 of the functional layer is determined by a material forming the functional layer. For example, in the case of a silicon-based inorganic polymer, the refractive index n2 is from 1.75 to 2.0 and, in the case of a mixture in which TiO$_2$ is dispersed in a polymer, the refractive index n2 is from 1.8 to 2.0.

<First Electrode>

The first electrode 4 of the present embodiment is realized by a thin film displaying light permeability and conductivity, and is constituted by, e.g., a metal oxide film, a metal thin film, or the like. Examples of the thin film include thin films made of iridium oxide, zinc oxide, tin oxide, indium tin oxide (its abbreviation is ITO), indium zinc oxide (its abbreviation is IZO), gold, platinum, silver, and copper, and the thin films made of ITO, IZO, and tin oxide are preferable. As the first electrode 4, there may be used transparent conductive films made of organic substances such as polyaniline or its derivative, and polythiophene or its derivative. The thickness of the first electrode 4 can be appropriately set in consideration of optical transmission and conductivity, and the thickness thereof is from about 10 nm to about 10 $\mu$m in general, preferably from 20 nm to 1 $\mu$m, and more preferably from 50 nm to 500 nm.
Examples of a method for forming the first electrode include a vacuum vapor deposition method, a sputtering method, an ion-plating method, and a plating method.
The refractive index n1 of the first electrode is determined by a material forming the first electrode. For example, in the case of ITO, the refractive index n1 is 2.0, in the case of IZO, the refractive index n1 is from 1.9 to 2.0, and, in the case of the transparent conductive film made of the organic substance such as polythiophene or its derivative, the refractive index n1 is about 1.7.

<Hole Injecting Layer>

Examples of a hole injecting material forming the hole injecting layer include a phenylamine-based compound, a starburst-type amine-based compound, a phthalocyanine-based compound, oxides such as vanadium oxide, molybdenum oxide, ruthenium oxide, and aluminum oxide, amorphous carbon, polyaniline, and a polythiophene derivative.
It is possible to form the hole injecting layer by, e. g. , applying an application liquid containing a material which is to serve as the hole injecting layer onto the first electrode 4. Examples of a method for applying the application liquid include a spin coating method, a casting method, a micro gravure coating method, a gravure coating method, a bar coating method, a roll coating method, a wire bar coating method, a dip coating method, a spray coating method, a screen printing method, a flexographic printing method, an offset printing method, and an inkjet printing method.

<Light Emitting Layer>

The light emitting layer is constituted to include an organic substance which is capable of emitting fluorescence and / or phosphorescence, or the organic substance and a dopant. The dopant is added for the purpose of, e.g. , improving luminous efficiency or changing luminous wavelength. The organic substance used in the light emitting layer may be a low molecular compound or a high molecular compound. Examples of a light emitting material forming the light emitting layer include the following materials.
Examples of a dye-based light emitting material include a cyclopendamine derivative, a tetraphenylbutadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perynone derivative, a perylene derivative, an oligothiophene derivative, an oxadiazole dimer, and a pyrazoline dimer.
Examples of a metal complex-based light emitting material include metal complexes each having, as a center metal, Ir, Pt, A1, Zn, or Be, or a rare earth metal such as Tb, Eu, or Dy, and having, as a ligand, oxadiazole, thiadiazole, phenylpyridine, phenylbenzimidazole, or a quinoline structure, and examples of the metal complexes include a metal complex having light emission from a triplet excitation state such as an iridium complex, a platinum complex, or the like, an alumiquinolinol complex, a benzoquinolinol beryllium complex, a benzoxazolyl zinc complex, a benzothiazole zinc complex, an azomethyl zinc complex, a porphyrin zinc complex, and an europium complex.
Examples of a polymer-based light emitting material include a polyparaphenylenevinylene derivative, a polythiophene derivative, a polyparaphenylene derivative, a polysilane derivative, a polyacetylene derivative, a polyfluorene derivative, a polyvinylcarbazole derivative, and materials obtained by polymerizing the above-mentioned dye-based light emitting materials or metal complex-based light emitting materials.
Among the above-mentioned light emitting materials, examples of a material emitting blue light include the distyrylarylene derivative, the oxadiazole derivative, and their polymers, the polyvinylcarbazole derivative, the polyparaphenylene derivative, and the polyfluorene derivative. Among them, the polyvinylcarbazole derivative, the polyparaphenylene derivative, and the polyfluorene derivative, which are the polymer-based materials, are preferable.
Examples of a material emitting green light include a quinacridone derivative, a coumarin derivative, and their polymers, the polyparaphenylenevinylene derivative, and the polyfluorene derivative. Among them, the polyparaphenylenevinylene derivative and the polyfluorene derivative, which are the polymer-based materials, are preferable.

Examples of a material emitting red light include the coumarin derivative, the thiophene ring compound, and their polymers, the polyparaphenylenevinylene derivative, the polythiophene derivative, and the polyfluorene derivative. Among them, the' polyparaphenylenevinylene derivative, the polythiophene derivative, and the polyfluorene derivative, which are the polymer-based materials, are preferable.

As a material emitting white light, a material obtained by mixing the above-mentioned materials emitting blue, green, and red lights may be used. It is possible to use, as the material emitting white light, a material having respective components of a plurality of types of the above-mentioned materials emitting blue, green, and red lights in one molecule and, for example, a polymer obtained by polymerizing the components of the materials of the individual colors as monomers may be used as the material emitting white light. By laminating a plurality of layers which emit lights of different colors, a device emitting white light may also be realized.

Examples of a material for the dopant include a perylene derivative, a coumarin derivative, a rubrene derivative, a quinacridone derivative, a squalium derivative, a porphyrin derivative, a styryl-based dye, a tetracene derivative, a pyrazolone derivative, decacyclene, and phenoxazone. The thickness of such light emitting layer is generally from about 2 nm to about 2000 nm.

Examples of a method for forming the light emitting layer containing the organic substance include a method in which an application liquid containing the light emitting material is applied to the hole injecting layer 7, the vacuum vapor deposition method, and a transfer method. A solvent for the application liquid containing the light emitting material may be any liquid capable of dissolving the light emitting material, and examples of the solvent include chlorine-based solvents such as chloroform, methylene chloride, and dichloroethane, ether-based solvents such as tetrahydrofuran and the like, aromatic hydrocarbon-based solvents such as toluene and xylene, ketone-based solvents such as acetone and methyl ethyl ketone, and ester-based solvents such as ethyl acetate, butyl acetate, and ethyl cellosolve acetate.

Examples of a method for applying the application liquid containing the light emitting material include application methods such as coating methods such as the spin coating method, the casting method, the micro gravure coating method, the gravure coating method, the bar coating method, the roll coating method, the wire bar coating method, the dip coating method, a slit coating method, a capillary coating method, the spray coating method, and a nozzle coating method, and a gravure printing method, the screen printing method, the flexographic printing method, the offset printing method, a reverse printing method, and the inkjet printing method. In terms of easiness in pattern formation and separate application of plural colors, the application methods such as the gravure printing method, the screen printing method, the flexographic printing method, the offset printing method, the reverse printing method, and the inkjet printing method are preferable. In addition, in the case of a sublimable low-molecular compound, the vacuum vapor deposition method can be used. Further, it is also possible to form the light emitting layer only at a desired portion by a method such as a transfer or thermal transfer using a laser.

<Second Electrode>

The second electrode 6 functions as a negative electrode in the present embodiment and, as a material for such second electrode, a material in which work function is small and injection of electrons into the light emitting layer is easy is preferable, and a material having high electric conductivity is preferable. Specifically, it is possible to use metals such as an alkali metal, an alkali earth metal, a transition metal, and a Group III-B metal. More specifically, there are used metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, or an alloy of two or more of the above-mentioned metals, or an alloy of one or more of the above-mentioned metals and one or more of gold, silver, platinum, copper, manganese, titanium, cobalt, nickel, tungsten, and tin, or graphite or a graphite interlayer compound. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. When light is extracted also from the second electrode, the second electrode needs to be transparent, and such transparent second electrode is constituted by a laminated body obtained by laminating thin films made of the above-mentioned materials and thin films made of a conductive metal oxide and a conductive organic substance.

As a combination of the above-described low refractive index layer 2, functional layer 3, and first electrode 4 in the present embodiment, a combination of the glass substrate, the inorganic polymer, and ITO is preferable, and a combination of the resin, the inorganic polymer, and ITO is more preferable.

In the organic EL device 1 of the present embodiment, although the hole injecting layer 7 and the light emitting layer 5 are disposed between the first electrode 4 and the second electrode 6, the structure of the organic EL device 1 is not limited to the structure shown in FIG. 1. A description will be given hereinbelow of an example of a device structure between the first and second electrodes of the organic EL device. It is to be noted that, since the first electrode may be the positive electrode or the negative electrode as long as the first electrode is transparent, the example of the device structure will be described in the following description without specifying polarities of the first and second electrodes. In addition, when the low refractive index layer 2 is formed of, e.g., a film made of a resin or the like, the low refractive index layer may be provided on a substrate made of glass or the like.

As described above, it is sufficient to provide at least one layer of the light emitting layer between the positive and negative electrodes, and a plurality of light emitting layers and / or one or a plurality of layers different from the light emitting layers may also be provided between the positive and negative electrodes.

Examples of the layer provided between the negative electrode and the light emitting layer include an electron injecting layer, an electron transporting layer, and a hole blocking layer. When both of the electron injecting layer and the electron transporting layer are provided between the negative electrode and the light emitting layer, a layer positioned closer to the negative electrode is referred to as the electron injecting layer, while a layer positioned closer to the light emitting layer is referred to as the electron transporting layer.

The electron injecting layer is a layer having a function of improving electron injection efficiency from the negative electrode. The electron transporting layer is a layer having a function of improving electron injection from the negative electrode or the electron injecting layer or the electron transporting layer closer to the negative electrode. The hole blocking layer is a layer having a function of blocking the transport of the hole. It is to be noted that there are cases where the electron injecting layer or the electron transporting layer serves as the hole blocking layer.

Examples of the layer provided between the positive electrode and the light emitting layer include the hole injecting layer, a hole transporting layer, and an electron blocking layer. When both of the hole injecting layer and the hole transporting layer are provided between the positive electrode and the light emitting layer, a layer positioned closer to the positive electrode is referred to as the hole injecting layer, while a layer positioned closer to the light emitting layer is referred to as the hole transporting layer.

The hole injecting layer is a layer having a function of improving hole injection efficiency from the positive electrode. The hole transporting layer is a layer having a function of improving hole injection from the positive electrode or the hole injecting layer, or the hole transporting layer closer to the positive electrode. The electron blocking layer is a layer having the function of blocking the transport of the electron. There are cases where the hole injecting layer or the hole transporting layer serves as the electron blocking layer.

The electron injecting layer and the hole injecting layer are collectively referred to as a charge injecting layer occasionally, and the electron transporting layer and the hole transporting layer are collectively referred to as a charge transporting layer occasionally.

Specific examples of a layer structure which the organic EL device can adopt are shown below.

a) positive electrode/hole transporting layer/light emitting layer/negative electrode
b) positive electrode/light emitting layer/electron transporting layer/negative electrode
c) positive electrode/hole transporting layer/light emitting layer/electron transporting layer/negative electrode
d) positive electrode/charge injecting layer/light emitting layer/negative electrode
e) positive electrode/light emitting layer/charge injecting layer/negative electrode
f) positive electrode/charge injecting layer/light emitting layer/charge injecting layer/negative electrode
g) positive electrode/charge injecting layer/hole transporting layer/light emitting layer/negative electrode
h) positive electrode/hole transporting layer/light emitting layer/charge injecting layer/negative electrode
i) positive electrode/charge injecting layer/hole transporting layer/light emitting layer/charge injecting layer/negative electrode
j) positive electrode/charge injecting layer/light emitting layer/charge transporting layer/negative electrode
k) positive electrode/light emitting layer/electron transporting layer/charge injecting layer/negative electrode
l) positive electrode/charge injecting layer/light emitting layer/electron transporting layer/charge injecting layer/negative electrode
m) positive electrode/charge injecting layer/hole transporting layer/light emitting layer/charge transporting layer/negative electrode
n) positive electrode/hole transporting layer/light emitting layer/electron transporting layer/charge injecting layer/negative electrode
o) positive electrode/charge injecting layer/hole transporting layer/light emitting layer/electron transporting layer/charge injecting layer/negative electrode (herein, a symbol "/" denotes that two layers sandwiching the symbol "/" are laminated adjacent to each other. The same applies to the description shown below.)

The organic EL device of the present embodiment may have two or more light emitting layers. A specific example of the organic EL device having two light emitting layers includes the organic EL device having the layer structure shown below. p) positive electrode/charge injecting layer/hole transporting layer/light emitting layer/electron transporting layer/charge injecting layer/electrode/charge injecting layer/hole transporting layer/light emitting layer/electron transporting layer/charge injecting layer/negative electrode

With regard to the organic EL device having three or more light emitting layers, when (electrode/charge injecting layer/hole transporting layer/light emitting layer/electron transporting layer/charge injecting layer) is assumed to be one repetitive unit, an example of the organic EL device includes the one having the layer structure including two or more repetitive units as shown below.

q) positive electrode/charge injecting layer/hole transporting layer/light emitting layer/electron transporting layer/charge injecting layer/repetitive unit/repetitive unit/···/negative electrode

In the layer structures p and q, it is possible to delete layers other than the positive electrode, the electrode, the negative electrode, and the light emitting layer as necessary.

In a bottom emission type organic EL device in which light is extracted from the substrate 8, all layers disposed on the side with the substrate 8 relative to the light emitting layer are constituted by transparent layers. As will be described later, in what is called a top emission type organic EL device in which light is extracted from the side opposite to the side with the substrate relative to the light emitting layer, all layers disposed on the side opposite to the side with the substrate relative to the light emitting layer are constituted by transparent layers.

In the organic EL device, an insulating layer having a film thickness of not more than 2 nm may be provided adjacent to the electrode in order to further enhance adherence to the electrode and improve the charge injection from the electrode, and a thin buffer layer may also be inserted at the interface of the adjacent layers described above in order to enhance adherence at the interface and prevent mixture.

A description will be given hereinbelow of a specific structure of each layer. The light emitting layer 5 and the hole injecting layer 7 have already been described so that the repeated description thereof will be omitted. The first electrode or the second electrode described above can be used as the positive electrode and / or the negative electrode so that the repeated description thereof will be omitted.

<Hole Transporting Layer>

Examples of a hole transporting material forming the hole transporting layer include polyvinylcarbazole or its derivative, polysilane or its derivative, a polysiloxane derivative having aromatic amine in its side chain or main chain, a pyrazoline derivative, an arylamine derivative, a stilbene derivative, a triphenyldiamine derivative, polyaniline or its derivative, polythiophene or its derivative, polyarylamine or its derivative, polypyrrole or its derivative, poly (p - phenylenevinylene) or its derivative, and poly (2, 5 - thienylenevinylene) or its derivative.

Among these hole transporting materials, as the hole transporting materials, polymeric hole transporting materials such as polyvinylcarbazole or its derivative, polysilane or its derivative, the polysiloxane derivative having an aromatic amine compound group in its side chain or main chain, polyaniline or its derivative, polythiophene or its derivative, polyarylamine or its derivative, poly (p - phenylenevinylene) or its derivative, and poly (2, 5 - thienylenevinylene) or its derivative are preferable, and polyvinylcarbazole or its derivative, polysilane or its derivative, and the polysiloxane derivative having aromatic amine in its side chain or main chain are more preferable. In the case of a low molecular hole transporting material, it is preferable to use the low molecular hole transporting material by dispersing it in a polymeric binder.

In the case of the low molecular hole transporting material, an example of a method for forming the hole transporting layer includes a method utilizing film formation from a solution mixed with a polymeric binder and, in the case of the polymeric hole transporting material, an example of the method includes a method utilizing film formation from a solution.

A solvent used in the film formation from the solution may be any solvent capable of dissolving the hole transporting material, and examples of the solvent include chlorine-based solvents such as chloroform, methylene chloride, and dichloroethane, ether-based solvents such as tetrahydrofuran and the like, aromatic hydrocarbon-based solvents such as toluene and xylene, ketone-based solvents such as acetone and methyl ethyl ketone, and ester-based solvents such as ethyl acetate, butyl acetate, and ethyl cellosolve acetate.

Examples of the method utilizing the film formation from the solution include application methods such as the spin coating method, the casting method, the micro gravure coating method, the gravure coating method, the bar coating method, the roll coating method, the wire bar coating method, the dip coating method, the spray coating method, the screen printing method, the flexographic printing method, the offset printing method, and the inkjet printing method.

As the the polymeric binder to be mixed, a binder which dose not excessively inhibit the charge transport is preferable, and a binder which is not apt to absorb visible light is preferably used. Examples of the polymeric binder include polycarbonate, polyacrylate, polymethyl acrylate, polymethyl methacrylate, polystyrene, polyvinyl chloride, and polysiloxane.

With regard to the film thickness of the hole transporting layer, the optimum value thereof differs depending on the material to be used, and the film thickness is selected such that values of a driving voltage and luminous efficiency are adequate. Further, it is necessary to have at least the thickness which prevents the occurrence of pinholes and, when the film thickness is too thick, the driving voltage of the device is increased, which is not preferable. Therefore, the film thickness of the hole transporting layer is, e.g., from 1 nm to 1 $\mu$m, preferably from 2 nm to 500 nm, and more preferably from 5 nm to 200 nm.

<Electron Injecting Layer>

Examples of an electron injecting material forming the electron injecting layer include an alkali metal, and an alkali earth metal, or an alloy including one or more metals mentioned above, or oxides, halogenides, and carbonates of the above-mentioned metals, or mixtures of the above-mentioned substances in accordance with the type of the light emitting layer. Examples of the alkali metal or its oxide, halogenide, and carbonate include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkali earth metal or its oxide, halogenide, and carbonate include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injecting layer may be a laminated body obtained by laminating two or more layers. Specific examples of the laminated body include LiF/Ca and the like. The electron injecting layer is formed by a vapor deposition method, the sputtering method, a printing method, and the like. The film thickness of the electron injecting layer is preferably from about 1nm to about 1 $\mu$m.

<Electron Transporting Layer>

Examples of an electron transporting material forming the electron transporting layer include an oxadiazole derivative, anthraquinodimethane or its derivative, benzoquinone or its derivative, naphthoquinone or its derivative, anthraquinone or its derivative, tetracyanoanthraquinodimethane or its derivative, a fluorene derivative, diphenyldicyanoethylene or its derivative, a diphenoquinone derivative, 8 - hydroxyquinoline or a metal complex of its derivative, polyquinoline or its derivative, polyquinoxaline or its derivative, and polyfluorene or its derivative.
Among them, as the electron transporting material, the oxadiazole derivative, benzoquinone or its derivative, anthraquinone or its derivative, 8 - hydroxyquinoline or the metal complex of its derivative, polyquinoline or its derivative, polyquinoxaline or its derivative, and polyfluorene or its derivative are preferable, and 2 - (4 - biphenylyl) - 5 - (4 - t - butylphenyl) - 1, 3, 4 - oxadiazole, benzoquinone, anthraquinone, tris (8 - quinolinol) aluminum, and polyquinoline are more preferable.
FIG. 2 is a view schematically showing an organic EL device 11 according to another embodiment of the present invention. The organic EL device 11 of the present embodiment is an organic electroluminescent device constituted by laminating at least a functional layer 13, a transparent first electrode 14, a light emitting layer 15, and a second electrode 16 in this order in which a plurality of depressions and projections having a height of 0.5 $\mu$m to 100 $\mu$m are formed on the surface of the functional layer 13 on the side opposite to the side with the first electrode 14, and the refractive index n1 of the first electrode 14 and the refractive index n2 of the functional layer satisfy Expression (1) described above. In the organic EL device 11 of the present embodiment, similarly to the case described above, a layer different from the light emitting layer 15 may be provided between the first electrode 14 and the second electrode 16, and it is possible to adopt various layer structures as described above. In the organic EL device 11 of the present embodiment, on the surface of a substrate 18, the second electrode 16, a hole injecting layer 14, the light emitting layer 15, the first electrode 14, and the functional layer 13 are provided adjacent to each other in this order.
The organic EL device 11 of the present embodiment is what is called a top emission type device in which light emitted from the light emitting layer 15 is extracted to the outside through the first electrode 14 and the functional layer 13.
The substrate 18 of the present embodiment may be transparent or opaque, and is a plate made of, e.g., the same material as that of the above-mentioned low refractive index layer 2. As the first electrode 14 of the present embodiment, there may also be used the first electrode 4 of the above-described embodiment and, similarly to the transparent second electrode 6 described in the foregoing embodiment, there may also be used the laminated body obtained by laminating the metal thin film made of the alkali metal, the alkali earth metal, the transition metal, or the Group III-B metal and the thin film made of the conductive metal oxide or the conductive organic substance. In addition, the second electrode 16 of the present embodiment may be transparent or opaque, and the first electrode 4 or the second electrode 6 of the above-described embodiment may also be used as the second electrode 16. Further, there may also be provided a reflecting layer made of a material which reflects light such as, e.g., a metal or the like on one surface of the second electrode 16.
The functional layer 13 of the present embodiment is the same as the functional layer 3 of the above-described embodiment so that the repeated description thereof will be omitted. After the depressions and projections are formed by using the same method as that for the functional layer 3 of the above-described embodiment, the functional layer 13 of the present embodiment may be laminated with the first electrode 12. Alternatively, after the plurality of depressions and projections are formed on the functional layer 3 by using the same method as the method by which the low refractive index layer 2 is formed in the above-described embodiment, the functional layer 3 may be laminated with the first electrode 12 or formed directly on the first electrode 14.

In the thus-structured organic EL device 11, since the difference between the refractive indexes of the first electrode 14 and the functional layer 13 is small, it is possible to reduce reflectivity at the interface between the functional layer 13 and the first electrode 14, and suppress the total reflection at the interface therebetween. This allows light to efficiently enter the functional layer 3 from the first electrode 4. In addition, since the plurality of depressions and projections having the height of 0.5 $\mu$m to 100 $\mu$m are formed on the surface of the functional layer 13, similarly to the case described above, light having entered the functional layer 13 is efficiently extracted to the outside. As has been discussed thus far, light emitted from the light emitting layer 15 is caused to efficiently propagate to the first electrode 14, the functional layer 13, and the air sequentially so that it is possible to improve light extraction efficiency.

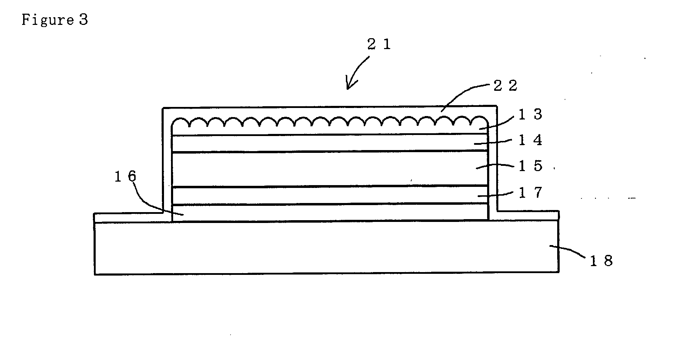

FIG. 3 is a view schematically showing an organic EL device 21 according to still another embodiment of the present invention. The organic EL device 21 of the present embodiment is the top emission type device obtained by adding a low refractive index layer 22 to the organic EL device 11 of the above-described embodiment shown in FIG. 2, and is different from the organic EL device 11 of the above-described embodiment only in that the low refractive index layer 22 is provided so that the repeated description thereof will be omitted and only the low refractive index layer 22 will be described.

The low refractive index layer 22 of the present embodiment functions as a sealing layer which shields the organic EL device 21 from water and oxygen, and an inorganic layer made of, e.g., a metal, a metal oxide, a metal nitride, a metal carbide, or a metal oxynitride, or a layer in which the inorganic layer is combined with an organic layer, or an inorganic-organic hybrid layer is preferably used as the low refractive index layer 22. As the inorganic layer, a thin film layer which is stable in the air is preferable, and specific examples of the thin film layer include thin film layers made of silica, alumina, titania, indium oxide, tin oxide, titanium oxide, zinc oxide, indium tin oxide, aluminum nitride, silicon nitride, silicon carbide, silicon oxynitride, and a combination thereof. The thin film layers made of aluminum nitride, silicon nitride, and silicon oxynitride are more preferable, and the thin film layer made of silicon oxynitride is even more preferable. The low refractive index layer 22 is formed so as to cover the second electrode 16, the hole injecting layer 17, the light emitting layer 15, the first electrode 14, and the functional layer 13 by the vacuum vapor deposition method, the sputtering method, or a laminating method in which a metal thin film is subjected to thermocompression bonding.

The refractive index n3 of the low refractive index layer 22 of the present embodiment satisfies Expression (2) described above. This causes light emitted from the light emitting layer 15 to efficiently propagate to the first electrode 14, the functional layer 13, the low refractive index layer 22, and the air sequentially, similarly to the organic EL device 1 shown in FIG. 1, whereby it is possible to improve light extraction efficiency.

By using the organic EL devices 1 and 11 of the above-described individual embodiments, it is possible to realize a lighting unit having the organic EL device, or a display unit having a plurality of the organic EL devices.

It is possible to use the organic EL device of each of the above-described embodiments as a lighting unit, a flat light source, a light source for a segment display unit or a dot matrix display unit, and a backlight of a liquid crystal display unit, and preferably use the organic EL device especially as the lighting unit.

When the organic EL device of the present embodiment is used as the flat light source, for example, flat positive and negative electrodes may be disposed so as to be stacked on each other when viewed in one of lamination directions. In addition, in order to constitute an organic EL device which emits light in a predetermined pattern by using the organic EL device as the light source for the segment display unit, there are usable a method in which a mask formed with windows through which light is passed in a predetermined pattern is placed on the surface of the flat light source, a method in which the organic layer at a portion where light emission should be blocked is formed extremely thickly so that no light is substantially emitted, and a method in which at least one of the positive electrode and the negative electrode is formed in a predetermined pattern. The organic EL device which emits light in a predetermined pattern is formed by these methods, and wiring is carried out such that a voltage can be selectively applied to several electrodes, whereby it is possible to realize the segment type display unit capable of displaying figures, characters, and simple symbols. In order to use the organic EL device as the light source for the dot matrix display unit, the positive and negative electrodes may be formed into a stripe shape, and disposed so as to be orthogonal to each other when viewed in one of lamination directions. In order to realize the dot matrix display unit capable of partial color display and multi-color display, there may be used a method in which a plurality of types of light emitting materials having different luminescent colors are separately applied, and a method in which a color filter, a fluorescence conversion filter, and the like are used. The dot matrix display unit may be passively driven, and may also be actively driven in combination with TFT. These display units can be used as display units for a computer, a television, a personal digital assistant, a cellular phone, a car navigation system, a view finder of a video camera, and the like.

Further, the above-mentioned flat light source is a thin self light emitting type, and can be preferably used as the backlight for the liquid crystal display unit or a flat lighting unit. In addition, when a flexible substrate is used, the flat light source can be used as a curved light source or a curved display unit.

Example 1

<Production of Substrate>

On a glass substrate of a size of 5 cm x 5 cm, a transparent positive photoresist material (manufactured by TOKYO OHKA KOGYO CO., LTD., commercial name: "TFR970", refractive index: 1.59) having a refractive index substantially similar to that of the glass substrate (refractive index: 1.52) was formed into a film having a film thickness of 5 $\mu$m using a spin coater, and the film was heated at 110°C for 110 seconds on a hot plate. By using a photomask on which circular light transmitting regions each having a diameter of 8.5 $\mu$m were randomly disposed, the film was irradiated with I line of 50 mJ / cm$^2$. The film was developed using a KOH aqueous solution of 0.55% at room temperature (80 seconds), and heated at 220°C for 1 minute on the hot plate to be subjected to reflow processing, whereby an irregular roughness structure having a height of 0.5 to 4.5 $\mu$m was formed on the surface of the photoresist film (formation of low refractive index layer). A liquid for forming a high refractive index application film having a refractive index of 1.8 (manufactured by RASA INDUSTRIES, LTD., commercial name: "RASA TI") was spin-coated onto the roughness structure, and was heat-cured at 200°C for 5 minutes on the hot plate (formation of functional layer). At this time, the center line average roughness Ra on the uppermost surface of the functional layer was 2.8 nm. Subsequently, while the substrate was heated at 120°C, ITO (refractive index: 2.0) was formed into a film having a film thickness of 300 nm in a belt-like shape of a size of 5 cm x 2 cm on the functional layer by sputtering (DC sputtering method, film forming pressure: 0.25 Pa, power: 0.25 kW) (formation of transparent electrode). Thereafter, an annealing process was performed at 200°C for 40 minutes in an oven. The substrate was subjected to ultrasonic cleaning using a strong alkaline detergent of 50°C, cold water, and hot water of 50°C, moved out of the hot water of 50°C, and further dried in the oven. Thereafter, the substrate was subjected to UV ozone cleaning for 20 minutes, and a transparent first electrode was thereby obtained.

<Production of Organic EL Device>

A liquid obtained by filtering a suspension of poly (3, 4) ethylenedioxythiophene/polystyrene sulfone acid (manufactured by H.C. Starck - V TECH Ltd., commercial name: AI 4083) using a filter having a diameter of 0.45 $\mu$m was applied on the substrate having subjected to the cleaning to a thickness of 65 nm by spin coating to form a thin film. The thin film was subjected to a heat treatment at 200°C for 15 minutes on the hot plate in an air atmosphere to form a hole injecting layer. Subsequently, as a material for a while polymeric organic EL light emitting layer, WP 1330 manufactured by SUMATION CO. , LTD. was dissolved in toluene to prepare a polymeric solution of 0.8% by mass, and the polymeric solution was spin-coated on the substrate formed with the hole injecting layer to form a film having a film thickness of 80 nm. Thereafter, the film was subjected to the heat treatment at 130°C for 30 minutes on the hot plate in a nitrogen atmosphere to form a light emitting layer. The substrate formed with the light emitting layer was loaded in a vacuum vapor deposition apparatus, and Ba and Al as a negative electrode were successively deposited to respective thicknesses of 10 nm and 100 nm in a belt-like shape of a size of 5 cm $\times$ 2 cm so as to be orthogonal to an ITO pattern to form a second electrode. In the step of forming the second electrode, the deposition of metals were started after the degree of vacuum reached not more than $1 \times 10^{-4}$ Pa. Lastly, in an inert gas, after the substrate was covered with a glass plate with a portion where the first and second electrodes were orthogonal to each other as the center and four sides thereof were covered with a photo-setting resin, the photo-setting resin was cured by UV irradiation to produce an organic EL device.

(Comparative Example 1)

<Production of Substrate>

The ITO thin film was formed on the glass substrate of the size of 5 cm $\times$ 5 cm (refractive index: 1.52) in the same manner as in Example 1.

<Production of EL device>

The organic EL device was produced on the substrate formed with the ITO thin film in the same manner as in Example 1.

<Evaluation of Light emitting properties of Organic EL Device>

Light emitting properties of the organic EL devices obtained in each of Example 1 and Comparative Example 1 were evaluated. The front luminance when a voltage of 8 V was applied to the entire device was measured. BM-8 was used as a lightmeter. The luminance of the organic EL device of Comparative Example 1 was 4865 cd/m$^2$, while the luminance of the organic EL device of Example 1 was 5578 cd/m$^2$ Thus, in the organic electroluminescent device of the present invention, it was ascertained that the light extraction efficiency was improved by including the functional layer and the low refractive index layer.

Example 2

<Production of substrate>

On a frosted surface of a single-sided frosted glass substrate (refractive index: 1.52) of a size of 5 cm × 5 cm manufactured by SANWA FROST INDUSTRY CO. LTD. which corresponds to the low refractive index layer, a process of sequentially performing the following steps (1) to (3) was performed 8 times repeatedly to form a functional layer having a refractive index of 1.98. (1) Step of spin-coating the liquid for forming the high refractive index application film having the refractive index of 1.8 (manufactured by RASA INDUSTRIES, LTD., commercial name: "RASA TI"). (2) Step of heating at 150° for 1 minute on the hot plate. (3) Step of heat-curing at 380°C for 1 minute on the hot plate. The roughness structure on the frosted surface of the frosted glass substrate satisfied Rz = 1.998 μm, and the center line average roughness Ra of the uppermost surface of the functional layer was 8.8 nm. Subsequently, while the substrate was heated at 120°C, ITO (refractive index: 2.0) was formed into a film having a film thickness of 300 nm in a belt-like shape of a size of 5 cm × 2 cm on the functional layer by sputtering (DC sputtering method, film forming pressure: 0.25 Pa, power: 0.25 kW) to form a transparent electrode having a refractive index of 2.0. Thereafter, the anneal process was performed at 200°C for 40 minutes in the oven to obtain the substrate with the transparent first electrode.

<Evaluation of Light Extraction Efficiency using PL>

As a material for a green polymeric organic EL light emitting layer, GP 1300 manufactured by SUMATION CO. , LTD. was dissolved in toluene to prepare a polymeric solution of 1.2% by mass, and the polymeric solution was applied onto the ITO thin film of the substrate obtained in the above description by spin coating. The film thickness of the obtained application film was 100 nm. Ultraviolet ray of 365 nm was radiated from the side with the green polymeric organic EL light emitting layer to measure a PL intensity of green light emission from a back surface of the substrate. The PL intensity was 3020 (arbitrary unit). It is to be noted that PL is an abbreviation of photoluminescence in which a light emitting material is excited by light (photon) and light emission (luminescence) peculiar to the light emitting material is detected. The evaluation of the light extraction efficiency can be performed by assuming light resulting from PL as light resulting from EL. Herein, , the intensity of light obtained by detecting light, which has been emitted from the light emitting material and has entered the entire surface of the substrate by performing UV irradiation of 365 nm with respect to the light emitting layer, using an integrating sphere was measured.

Comparative Example 2

<Production of Substrate>

The ITO thin film was formed on the glass substrate (refractive index: 1.52) of the size of 5 cm × 5 cm in the same manner as in Example 2.

<Evaluation of Light Extraction Efficiency using PL>

The material for the green polymeric organic EL light emitting layer was applied onto ITO of the substrate obtained in the above description in the same manner as in Example 2. The ultraviolet ray of 365 nm was radiated from the side with the green polymeric organic EL light emitting layer, and the PL intensity of the green light emission from the back surface of the substrate was measured. The PL intensity was 2271 (arbitrary unit).

The PL intensity obtained in Example 2 was 1. 33 times the PL intensity obtained in Comparative Example 2. When the organic EL device is produced by using the substrate obtained in Example 2 in the same manner as in Example 1, the light extraction efficiency of the device is improved by including the functional layer and the low refractive index layer.

INDUSTRIAL APPLICABILITY

According to the present invention, it is possible to realize an organic electroluminescent device having high light extraction efficiency.

**Claims**

1. An organic electroluminescent device with a configuration in which a functional layer, a transparent first electrode, a light emitting layer, and a second electrode are disposed in layer in this order, wherein
a surface of the functional layer has a plurality of depressions and projections having a height of 0.5 $\mu$m to 100 $\mu$m, the surface being located on a side opposite to a side where the first electrode is, and
the refractive index n1 of the first electrode and the refractive index n2 of the functional layer satisfy the following Expression (1).

$$0.3 \geq n1 - n2 \geq 0 \quad \cdots \text{Expression (1)}$$

2. The organic electroluminescent device of claim 1, further comprising:

a low refractive index layer provided in contact with the surface of the functional layer, the surface being located on a side opposite to a side where the first electrode is, wherein the refractive index n1 of the first electrode, the refractive index n2 of the functional layer, and the refractive index n3 of the low refractive index layer satisfy the following Expression (2).

$$n1 \geq n2 > n3 \quad \cdots (2)$$

3. The organic electroluminescent device of claim 1 or 2, wherein the center line average roughness Ra of a surface of the functional layer, the surface facing the first electrode, is not more than 10 nm.

4. The organic electroluminescent device of any one of claims 1 to 3, wherein the interval at which the depressions and projections are disposed is from 0.5 $\mu$m to 100 $\mu$m.

5. The organic electroluminescent device of any one of claims 1 to 4, wherein the surface shape of each of the depressions and projections is a concave surface or a convex surface.

6. The organic electroluminescent device of claim 5, wherein the concave surface or the convex surface is a hemispherical surface.

7. The organic electroluminescent device of any one of claims 1 to 4, wherein the surface shape of each of the depressions and projections is constituted by a plurality of planes.

8. The organic electroluminescent device of any one of claims 1 to 4, wherein the depressions and projections are mutually irregular in shape.

9. A lighting unit comprising the organic electroluminescent device of any one of claims 1 to 8.

10. A display unit comprising a plurality of organic electroluminescent devices of any one of claims 1 to 8.

11. A method of manufacturing an organic electroluminescent device with a configuration in which a low refractive index layer, a functional layer, a transparent first electrode, a light emitting layer, and a second electrode are disposed in layer in this order,wherein the refractive index n1 of the first electrode, the refractive index n2 of the functional layer, and the refractive index n3 of the low refractive index layer satisfy the following Expression (3),

$$\begin{cases} 0.3 \geq n1 - n2 \geq 0 \\ n1 \geq n2 > n3 \end{cases} \cdots (3)$$

the method comprising the steps of:

forming a plurality of depressions and projections having a height of 0.5 μm to 100 μm on a surface to form the low refractive index layer;
applying an application liquid containing a material which is to form the functional layer to the surface provided with the plurality of depressions and projections of the low refractive index layer to form the functional layer;
forming the first electrode;
forming the light emitting layer; and
forming the second electrode.

12. The method of manufacturing the organic electroluminescent device of claim 11, wherein the plurality of depressions and projections are formed by an imprint method in the step of forming the low refractive index layer.

13. The method of manufacturing the organic electroluminescent device of claim 11, wherein a surface portion of the low refractive plate is selectively removed by a photolithography method to form the plurality of depressions and projections in the step of forming the low refractive index layer.

14. The method of manufacturing the organic electroluminescent device of claim 11, wherein a surface portion of the low refractive plate is selectively removed by dry etching to form the depressions and projections in the step of forming the low refractive index layer.

Figure 1

Figure 2

Figure 3

## INTERNATIONAL SEARCH REPORT

| | International application No. |
|---|---|
| | PCT/JP2009/056781 |

A. CLASSIFICATION OF SUBJECT MATTER
*H05B33/02*(2006.01)i, *H01L51/50*(2006.01)i, *H05B33/10*(2006.01)i

According to International Patent Classification (IPC) or to both national classification and IPC

B. FIELDS SEARCHED

Minimum documentation searched (classification system followed by classification symbols)
H01L51/50-51/56, H01L27/32, H05B33/00-33/28

Documentation searched other than minimum documentation to the extent that such documents are included in the fields searched

| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-296438 A  (Mitsubishi Chemical Corp.), 21 October, 2004 (21.10.04), Par. Nos. [0092] to [0098], [0106], [0111], [0117] to [0118] & US 2006/0049745 A1    & EP 1603367 A1 & WO 2004/089042 A1    & KR 10-2005-0111348 A | 1-14 |
| Y | JP 2008-66027 A  (Fuji Electric Holdings Co., Ltd.), 21 March, 2008 (21.03.08), Par. No. [0056]; Fig. 4 (Family: none) | 1-14 |
| Y | JP 2005-322490 A  (Nitto Denko Corp.), 17 November, 2005 (17.11.05), Par. Nos. [0030] to [0032]; Fig. 1 (Family: none) | 1-14 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 April, 2009 (24.04.09) | 12 May, 2009 (12.05.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2009/056781 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2007-227355 A (Samsung Electronics Co., Ltd.), 06 September, 2007 (06.09.07), Par. No. [0049] & US 2007/0138460 A1 & EP 1798783 A2 & KR 10-2007-0065080 A | 12,13 |

Form PCT/ISA/210 (continuation of second sheet) (April 2007)

**EP 2 278 855 A1**

**REFERENCES CITED IN THE DESCRIPTION**

**Patent documents cited in the description**

- JP 2003086353 A